# EUROPEAN PATENT SPECIFICATION

(11) **EP 0 194 134 B1**
(45) Date of publication and mention of the grant of the patent: **08.06.1994**
(21) Application number: 86301537.6
(22) Date of filing: 05.03.1986
(51) Int. Cl.: H03K 19/094

(54) **Semiconductor integrated circuit device**
Integrierte Halbleiterschaltung
Circuit intégré à semi-conducteur

(30) Priority: 06.03.1985 JP 42708/85
(43) Date of publication of application: 10.09.1986
(73) Proprietor: FUJITSU LIMITED, Kawasaki-shi, Kanagawa 211 (JP)
(72) Inventor: Kousaka, Kunimitsu, Nakahara-ku Kawasaki-shi Kanagawa 211 (JP); Gotoh, Kunihiko, Kunitachi-shi Tokyo 186 (JP)
(74) Representative: Billington, Lawrence Emlyn

(56) References cited:
- EP-A- 0 131 952
- EP-A- 0 143 699
- DE-A- 3 340 567
- US-A- 3 631 528
- US-A- 4 048 518
- US-A- 4 486 671
- IBM TECHNICAL DISCLOSURE BULLETIN, vol. 19, no. 5, October 1976, page 1829, 1830, New York, US; S. OGURA: "FET signal receiver for VTL circuits"

## Description

The present invention relates to a semiconductor integrated circuit for detecting a predetermined level of an input signal.

In a semiconductor integrated circuit, an input signal having an input level of a range narrower than the power supply voltage of the circuit (for example, when the power supply voltage is 10 V, an input signal with a level of 5 V) is often applied to its input circuit.

In some cases, the semiconductor integrated circuit will have a power supply voltage of a predetermined value (for example, 10 V), and the output signal of a previous semiconductor integrated circuit having a power supply source lower in value (for example, 5 V) will be input thereto. In other cases, the semiconductor integrated circuit may be a special one (for example, a metal-oxide semiconductor (MOS) circuit) and the output signal of a prior semiconductor integrated circuit (for example, a transistor-transistor logic (TTL) signal) with a different logic amplitude will be input thereto. In such cases, the later semiconductor integrated circuit receives an input signal with an input level of a range narrower than the power supply voltage, as mentioned above.

As the input circuit of such a semiconductor integrated circuit, use has been made of an inverter circuit including a pair of transistors, that is, a P channel transistor and N channel transistor, each having a gate connected to an input terminal.

In such an input circuit, as explained in detail hereinafter, both the P channel transistor and N channel transistor in the input circuit may end up ON at the same time, resulting in consumption of a large amount of power, and reducing the inverting speed. Further, there is the problem of only the N channel transistor being switched on and off along with variations in the input signal, whereupon the level change in the output obtained from the output terminal OUT becomes insufficient.

DE-A-3 340 567 discloses a voltage converter circuit according to the preamble of accompanying claim 1, having an inverter and a pull-up (level shift) circuit. Both of the complementary pair of transistors of the inverter are supplied directly or indirectly with an input signal, and the p-channel transistor has a parallel connection to the pull-up circuit which is responsive to the output of the inverter. The pull-up circuit boosts a high logic level of the input signal but is cut off (therefore having no effect) in the presence of a low logic level of the input signal.

EP-A-0 131 952 discloses a logic circuit whose purpose is to interface between BFL and ECL logic circuitry, and it uses a GaAs-MESFET-Push-Pull stage as an output driver having a variable power source voltage for outputting an ECL-level output signal.

US-A-3 631 528 discloses a complementary inverter provided with a special circuit to ensure that both transistors of the inverter can never be on at the same time. The special circuit comprises two additional complementary inverters having different transition voltages, interposed between the input signal and the first inverter. The effect of the special circuit is to vary the timings of the signals applied to the transistors of the first inverter. The output logic levels are unchanged relative to the input signal logic levels.

According to the present invention, there is provided a semiconductor integrated circuit comprising an inverter circuit including p-channel and n-channel transistors connected in series between first and second power supply lines and a level shift circuit arranged such that, in use, the p-channel transistor is supplied with an input signal via said level shift circuit, and the n-channel transistor is supplied with the input signal directly;
said level shift circuit having an amount of level shift such that when an input signal of a transition level for distinguishing a logic level in said inverter circuit is received, the level of said input signal via said level shift circuit is shifted near a threshold level of the p-channel transistor; characterised in that said level shift circuit comprises:-
first and second p-channel transistors connected in series and operatively connected between the first and second power supply lines, the connection point between the first and second p-channel transistors being connected to the gate of the inverter circuit p-channel transistor, the gate of the first p-channel transistor being connected to receive a predetermined bias voltage set near the threshold voltage of the inverter circuit p-channel transistor, and the gate of the second p-channel transistor being connected to receive the input signal; and
a level divider circuit operable to supply said bias voltage, comprising third to fifth transistors connected in series between the first and second power supply lines, said bias voltage being supplied from a connecting point between the third and fourth transistors.

An embodiment of the present invention may provide a semiconductor integrated circuit which can solve the above-mentioned problems of conventional circuits.

An embodiment of the present invention may provide a semiconductor integrated circuit having an input circuit which can precisely detect a level change in an input signal of an input level of a range narrower than the power supply source, and which operates stably and at a high speed without consuming excess power.

Reference is made, by way of example, to the accompanying drawings in which:
Figure 1 is a diagram for explaining an example of an input circuit in a conventional semiconductor integrated circuit;
Fig. 2 is a diagram of a basic construction of an input circuit in a semiconductor integrated circuit useful for explaining the present invention;
Fig. 3 is a detailed diagram of the input circuit of one embodiment of the semiconductor integrated circuit according to the present invention;
Fig. 4 is a diagram explaining electric potentials at various points when, in the circuit shown in Fig. 3, the input signal is input thereto; and
Fig. 5 is a detailed diagram of another embodiment of the semiconductor integrated circuit according to the present invention.

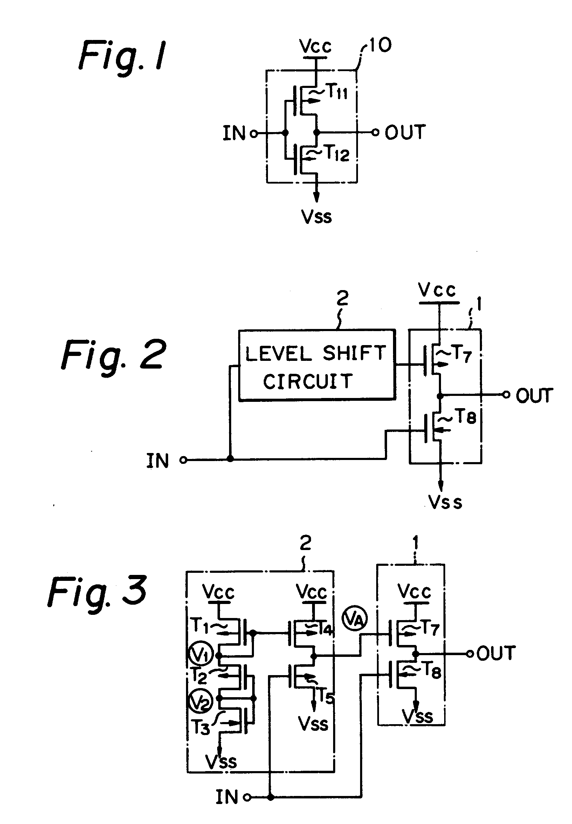

Figure 1 shows one example of a conventional circuit. The circuit shown in Fig. 1 uses an inverter circuit 10 including a pair of transistors (P channel transistor T₁₁ and N channel transistor T₁₂) each having a gate connected to a common input terminal.

Assume that the power supply voltage V_{CC} of the input circuit is 10 V and the input signal to the input terminal IN has a high level of 5 V and low level of 0 V. In such a case, if the input signal to the input terminal IN is low level, the P channel transistor T₁₁ turns on and the N channel transistor T₁₂ turns off. On the other hand, if the input signal to the input terminal IN is high level, while the N channel transistor T₁₂ turns on, the P channel transistor T₁₁ may not turn off depending on its threshold value as the potential of the gate connected to the input IN remains negative with respect to the source connected to the power supply V_{CC} (in this example, only 5 V is negative). This is due to the fact that the high level of the input signal is lower than the power supply voltage, so that the value of the high level does not exceed the threshold value V_{THP} of the P channel transistor T₁₁. This results in the problems described previously end up.

Figure 2 shows the basic construction of an input circuit in an IC, which is useful for explaining the present invention and which corresponds to DE-A-3 340 567. In Fig. 2,1 is an inverter formed by a pair of transistors (P channel transistor T₇ and N channel transistor T₈). An input signal from an input terminal IN is level shifted by a predetermined amount via a level shift circuit 2 and is supplied to a gate of the P channel transistor T₇. On the other hand, the input signal is supplied directly from the input terminal IN to a gate of the N channel transistor 8.

The level shift circuit 2 is formed so that when the inverter 1 receives an input signal having a level corresponding to the transition portion of two logic levels, by which the inverter 1 discriminates a high level and low level, the transition level is level shifted to near the threshold value of the P channel transistor T₇.

By such a construction, even if the level of the input signal is narrower in range than the power supply voltage of the integrated circuit (for example, when the power supply voltage of the integrated circuit is 10 V, the level of the input signal is only 5 V), the pair of the transistors T₇ , T₈ can be reliably turned ON and OFF in accordance with the level change (that is, the change between 0 V as low or "L" level and 5 V as high or "H" level).

That is, when the input level to the input terminal IN is low, the P channel transistor T₇ turns on and the N channel transistor T₈ turns off. On the other hand, when the input level to the input terminal IN is high, even if the level of the input signal is lower than the power supply voltage of the integrated circuit, as the level of the input signal is shifted (raised) by a predetermined amount via the level shift circuit 2 and input to the P channel transistor T₇ (that is, shifted until it exceeds the level of the threshold value of the P channel transistor T₇ to be input to the P channel transistor T₇), the P channel transistor T₇ reliably turns OFF and only the N channel transistor T₈ is ON. In this way, the two transistors are never ON together, unlike in the conventional example mentioned above, so the input circuit does not consume excess power and can operate rapid and stably.

Figure 3 shows in detail the input circuit of one embodiment of the semiconductor integrated circuit of the present invention, wherein the level shift circuit 2 shown in Fig. 2 is formed by transistors T₁ to T₅.

Here, transistors T₄ and T₅ are P channel transistors. A gate of the transistor 5 is input directly with the input signal from the input terminal IN. A gate of the transistor T₄ is supplied by the potential V₁ from the connecting point of the transistors T₁ and T₂ in a level divider circuit (bias circuit) formed by the transistors T₁ , T₂ , and T₃.

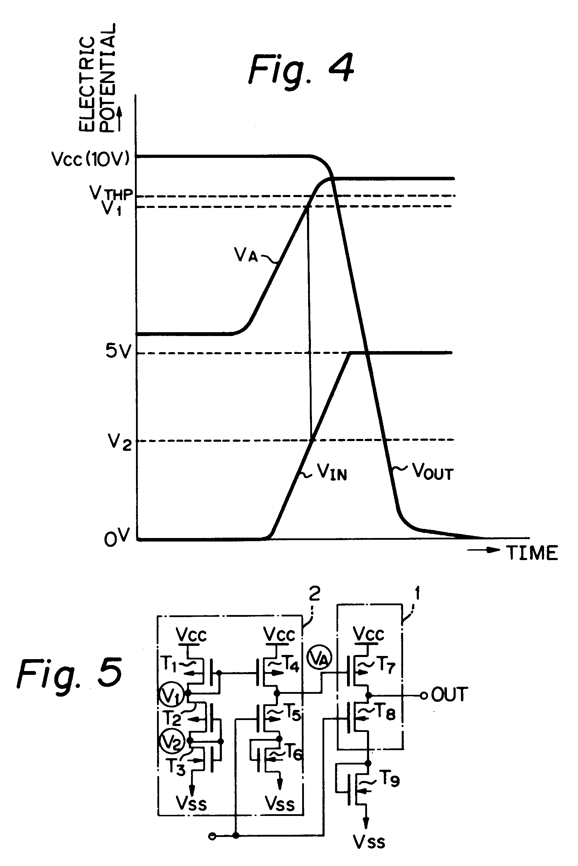

Here, the transistors T₁ , T₂ , and T₃ divide the level of the power supply voltage V_{CC} and supplies a predetermined bias voltage V₁ to the transistor T₄. They form a constant current source together with the transistor T₄. As shown in Fig. 4, the electric potential V₁ at the connection point of the transistors T₁ and T₂ is set at the level near the threshold level V_{THP} of the P channel transistor T₇ (under V_{THP} in Fig. 4), and the electric potential V₂ at the connection point of the transistors T₂ and T₃ is set at the transition level mentioned above (that is, the level corresponding to the level at the transition portion where the input signal V_{IN} , the logic level of which is discriminated by the inverter, is changed from low to high).

Further, as mentioned above, the transistor T₄ , having a gate where the predetermined bias voltage V₁ is supplied so as to form the constant current source, and the transistor T₅ , having a gate where the input signal is supplied from the input terminal IN, form a so-called source follower circuit. The electric potential V_{A} at the source side of the transistor T₅ is raised (level shifted) by the predetermined amount from the gate electric potential (which is the level of the input signal).

Figure 4 shows the change of the electric potential V_{A} (that is, the electric potential V_{A} applied to the gate of the P channel transistor T₇) when, in the circuit shown in Fig. 3, the level V_{IN} of the input signal is changed from low (0 V) to high (5 V). Further, as already mentioned, the potential V₁ (supplied to the gate of the transistor T₄) at the connection points between the transistors T₁ and T₂ is set at the electric potential near the threshold value V_{THP} of the P channel transistor T₇ , and the electric potential V₂ at the connection point between the transistors T₂ and T₃ is set at the level of the input signal which becomes the transition level mentioned above for the inverter circuit 1.

The amount by which the electric potential V_{A} at the source side of the transistor T₅ is shifted from its gate electric potential (which is in the level V_{IN} of the input signal) is set at a value such that the electric potential V_{A} is raised to the electric potential V₁ (that is, the electric potential near the threshold value V_{THP} of the P channel transistor V₇) when the level V_{IN} of the input signal is at the transition level V₂ as mentioned above. (Refer to Fig. 4).

In this way, when the level of the electric potential of the gate of the P channel transistor T₇ is shifted so that the level of the input signal exceeds the transition level V₂ (that is, becomes high level) for the inverter circuit, the electric potential V_{A} immediately exceeds the threshold value V_{THP} of the transistor T₇ , so the transistor T₇ reliably turns OFF. Further, in Fig. 4, V_{OUT} shows a level of the output signal which is output from the output terminal OUT. It is high level (10 V) when the level of the input signal is low level (0 V). When the level of the input signal becomes high level (5 V), the P channel transistor T₇ turns OFF. (At this time, the N channel transistor T₈ is in the ON state.) Therefore, the level of the output signal is reliably made low (0 V).

Figure 5 shows in detail an input circuit as another embodiment of the semiconductor integrated circuit of the present invention. In Fig. 5, a transistor T₆ is connected in series to a P channel transistor which forms a source follower circuit T₅. Provision of the transistor T₆ enables a balance between the transistor T₆ and the transistor T₃ in the level divider circuit (bias circuit), so the value of the currents which flow in the transistors T₄ and T₅ can easily be made a predetermined value.

In the embodiment shown in Fig. 5, the transistor T₉ is provided, connected in series to the N channel transistor T₈ so that if the low level side of the input signal is higher in level than the threshold value of the N channel transistor T₈ , the N channel transistor is reliably turned OFF.

That is, by providing the transistor T₉ , the potential at the source side of the N channel transistor T₈ is raised from the ground potential by the predetermined level (corresponding to the potential difference of one MOS diode). Then, if the low level of the input signal is in a predetermined level higher than 0 V, when the low level input signal is input, the N channel transistor T₈ is reliably turned OFF. The transistor T₈ is thus prevented from remaining ON, avoiding malfunctions of the circuit in the low level state of the input signal.

According to the present embodiment of the invention, there is provided a semiconductor integrated circuit with an input circuit wherein, even if an input signal having a level of a range narrower than the power supply voltage is input, its level changes can be exactly detected and a high speed, stable operation can be carried out without consumption of excess power.

## Claims

1. A semiconductor integrated circuit comprising an inverter circuit (1) including p-channel and n-channel transistors (T₇, T₈) connected in series between first and second power supply lines (V_{cc}, Vₛₛ) and a level shift circuit (2) arranged such that, in use, the p-channel transistor (T₇) is supplied with an input signal (IN) via said level shift circuit, and the n-channel transistor (T₈) is supplied with the input signal (IN) directly;
said level shift circuit (2) having an amount of level shift such that when an input signal of a transition level for distinguishing a logic level in said inverter circuit is received, the level of said input signal via said level shift circuit is shifted near a threshold level (V_{THP}) of the p-channel transistor (T₇); characterised in that said level shift circuit (2) comprises:-
first and second p-channel transistors (T₄, T₅) connected in series and operatively connected between the first and second power supply lines (V_{cc}, Vₛₛ), the connection point between the first and second p-channel transistors (T₄, T₅) being connected to the gate of the inverter circuit p-channel transistor (T₇), the gate of the first p-channel transistor (T₄) being connected to receive a predetermined bias voltage (V₁) set near the threshold voltage (V_{THP}) of the inverter circuit p-channel transistor (T₇), and the gate of the second p-channel transistor (T₅) being connected to receive the input signal (IN); and
a level divider circuit operable to supply said bias voltage (V₁), comprising third to fifth transistors (T₁, T₂, T₃) connected in series between the first and second power supply lines (V_{cc}, Vₛₛ), said bias voltage being supplied from a connecting point between the third and fourth transistors (T₁, T₂).

2. A semiconductor integrated circuit according to claim 1, wherein said level shift circuit (2) further comprises a sixth transistor (T₆) provided in series between said second p-channel transistor (T₅) and the second power supply line (Vₛₛ) so as to balance with said fifth transistor (T₃) of the level divider circuit.

3. A semiconductor integrated circuit as claimed in claim 1 or 2, wherein the inverter circuit (1) further comprises a further transistor (T₉) provided in series with said n-channel transistor (T₈) for raising the potential of the source of said n-channel transistor (T₈) by a predetermined amount.

## Patentansprüche

1. Integrierte Halbleiterschaltung, umfassend eine Inverterschaltung (1), die zwischen ersten und zweiten Spannungsversorgungsleitungen (V_{cc}, Vₛₛ) in Reihe geschaltete p-Kanal-Transistoren und n-Kanal-Transistoren (T₇, T₈) sowie eine Pegelumsetzschaltung (2) enthält, so eingerichtet, daß bei Gebrauch ein Eingangssignal (IN) über die Pegelumsetzschaltung an den p-Kanal-Transistor (T₇) angelegt wird und das Eingangssignal (IN) direkt an den n-Kanal-Transistor (T₈) angelegt wird,
wobei die Pegelumsetzschaltung (2) den Pegel so umsetzt, daß der Pegel des Eingangssignals über die Pegelumsetzschaltung in die Nähe einer Schwellenspannung (V_{THP}) des p-Kanal-Transistors (T₇) gelegt wird, falls als Eingangssignal ein Übergangspegel zum Unterscheiden von Logikpegeln in der Inverterschaltung empfangen wird;
dadurch gekennzeichnet, daß die Pegelumsetzschaltung (2) erste und zweite, in Reihe geschaltete p-Kanal-Transistoren (T₄, T₅) umfaßt, die funktionell zwischen der ersten und der zweiten Spannungsversorgungsleitung (V_{cc}, Vₛₛ) verbunden sind, wobei der Verbindungspunkt zwischen dem ersten und dem zweiten p-Kanal-Transistor (T₄, T₅) an das Gate des p-Kanal-Transistors (T₇) der Inverterschaltung angeschlossen ist und das Gate des ersten p-Kanal-Transistors (T₄) zum Empfang einer ersten vorherbestimmten Vorspannung (V₁) angeschlossen ist, die nahe an der Schwellenspannung (V_{THP}) des p-Kanal-Transistors (T₇) der Inverterschaltung liegt, und das Gate des zweiten p-Kanal-Transistors (T₅) zum Empfangen des Eingangssignals (IN) angeschlossen ist; und
eine Pegelteilerschaltung, betreibbar zum Anlegen der Vorspannung (V₁), umfassend dritte bis fünfte Transistoren (T₁, T₂, T₃), die zwischen der ersten und der zweiten Spannungsversorgungsleitung (V_{cc}, Vₛₛ) in Reihe geschaltet sind, wobei die Vorspannung von einem Verbindungspunkt zwischen dem dritten und vierten Transistor (T₁, T₂) angelegt wird.

2. Integrierte Halbleiterschaltung nach Anspruch 1, wobei die Pegelumsetzschaltung (2) zudem einen sechsten Transistor (T₆) enthält, der zwischen dem zweiten p-Kanal-Transistor (T₅) und der zweiten Spannungsversorgungsleitung (Vₛₛ) zum Ausgleich mit dem fünften Transistor (T₃) der Pegelteilerschaltung in Reihe bereitgestellt ist.

3. Integrierte Halbleiterschaltung nach Anspruch 1 oder 2, wobei die Inverterschaltung (1) zudem einen weiteren Transistor (T₉) enthält, bereitgestellt in Reihe mit dem n-Kanal-Transistor (T₈) zum Anheben des Source-Potentials des n-Kanal-Transistors (T₈) um einen vorbestimmten Betrag.

## Revendications

1. Circuit intégré à semiconducteur comprenant un circuit inverseur (1) incluant des transistors à canal p et à canal n (T₇, T₈) connectés en série entre une première et une seconde ligne de tension d'alimentation (V_{CC}, V_{SS}) et un circuit à décalage de niveau (2) agencé de telle sorte que, en fonctionnement, le transistor à canal p (T₇) reçoit un signal d'entrée (ENTREE) par l'intermédiaire dudit circuit à décalage de niveau, et le transistor à canal n (T₈) reçoit directement le signal d'entrée (ENTREE) ;
ledit circuit à décalage de niveau (2) comportant une quantité de décalage de niveau telle que, lorsqu'un signal d'entrée ayant un niveau de transition pour distinguer un niveau logique dans ledit circuit inverseur est reçu, le niveau dudit signal d'entrée passant par ledit circuit à décalage de niveau est décalé près d'un niveau de seuil (V_{THP}) du transistor à canal p (T₇) ;
caractérisé en ce que ledit circuit à décalage de niveau (2) comprend :
des premier et deuxième transistors à canal p (T₄, T₅) connectés en série et connectés activement entre la première et la seconde ligne de tension d'alimentation (V_{CC}, V_{SS}), le point de connexion entre le premier et le deuxième transistor à canal p (T₄, T₅) étant connecté à la grille du transistor à canal p (T₇) du circuit inverseur, la grille du premier transistor à canal p (T₄) étant connectée pour recevoir une tension de polarisation prédéterminée (V₁) réglée près de la tension de seuil (V_{THP}) du transistor à canal p (T₇) du circuit inverseur, et la grille du deuxième transistor à canal p (T₅) étant connectée pour recevoir le signal d'entrée (ENTREE) ; et,
un circuit diviseur de niveau pouvant être mis en fonctionnement pour fournir ladite tension de polarisation (V₁), comprenant des troisième à cinquième transistors (T₁, T₂, T₃) connectés en série entre la première et la seconde ligne de tension d'alimentation (V_{CC}, V_{SS}), ladite tension de polarisation étant fournie par un point de connexion entre le troisième et le quatrième transistor (T₁, T₂).

2. Circuit intégré à semiconducteur selon la revendication 1, dans lequel ledit circuit à décalage de niveau (2) comprend en outre un sixième transistor (T₆) prévu en série entre ledit deuxième transistor à canal p (T₅) et la seconde ligne de tension d'alimentation (V_{SS}) de manière à établir un équilibre avec ledit cinquième transistor (T₃) du circuit diviseur de niveau.

3. Circuit intégré à semiconducteur selon l'une quelconque des revendications 1 et 2, dans lequel le circuit inverseur (1) comprend en outre un autre transistor (T₉) prévu en série avec ledit transistor à canal n (T₈) pour élever le potentiel de la source dudit transistor à canal n (T₈) d'une quantité prédéterminée.
